# EUROPÄISCHE PATENTSCHRIFT

(11) **EP 0 334 084 B1**
(45) Veröffentlichungstag und Bekanntmachung des Hinweises auf die Patenterteilung: **02.02.1994**
(21) Anmeldenummer: 89103845.7
(22) Anmeldetag: 04.03.1989
(51) Int. Cl.: H01B 1/22, C08K 3/00

(54) **Verwendung einer siebdruckfähigen Paste zur Herstellung elektrisch leitender Ueberzüge auf flexiblen Kunststoffolien**
Use of a silk screen paste for manufacturing electrally conductive coatings on flexible plastic sheet materials
Utilisation d'une pâte sérigraphique pour la fabrication de revêtements électroconducteurs sur feuilles flexibles en matière plastique

(30) Priorität: 19.03.1988 DE 3809331
(43) Veröffentlichungstag der Anmeldung: 27.09.1989
(73) Patentinhaber: Degussa Aktiengesellschaft, 60311 Frankfurt (DE)
(72) Erfinder: Lutz, Klaus, Dr., Dipl.-Chem., D-6458 Rodenbach (DE); Baer, Hans-Joachim,, D-6000 Frankfurt 70 (DE); Starz, Karl-Anton, Dr., Dipl.-Chem., D-6458 Rodenbach (DE); Leske, Werner, Dr., Dipl.-Chem., D-6460 Gelnhausen (DE); Müller, Harry, D-6458 Rodenbach 1 (DE)

(56) Entgegenhaltungen:
- EP-A- 0 068 168
- FR-A- 2 505 543
- Epoxy Resins, Chemistry and Technology edited by Clayton A. May and Yoshio Tanaka, Marcel Dekker, Inc. 1973, New York, p. 474-475

## Beschreibung

Die Erfindung betrifft die Verwendung siebdruckfähiger Pasten, bestehend aus 40 bis 75 Gew. % eines elektrisch leitfähigen Metallpulvers auf der Basis von Silber, Aluminium, Kupfer und deren Gemischen, 5 bis 20 Gew. % eines organischen Kunstharzes und 5 bis 55 Gew. % eines organischen Lösungsmittels zur Herstellung elektrisch leitender Überzüge auf flexiblen Kunststoffolien, insbesondere zur Herstellung von Folientastaturen.

Zur Erzeugung dünner, elektrisch leitender Bahnen auf flexiblen Substraten, wie beispielsweise Polyesterfolien, werden siebdruckfähige Leitpasten benötigt, die nach dem Trocknen ebenfalls flexibel sein müssen. Haupteinsatzgebiet dieser Pasten sind Folientastaturen, die vor einigen Jahren auf dem Markt eingeführt wurden und aufgrund technischer Verbesserungen deutlich steigende Marktakzeptanz zeigen. Folientastaturen werden zur Zeit hauptsächlich in der Konsumerelektronik sowie in den Bedienungselementen von Maschinen und anderen technischen Geräten eingesetzt.

Der prinzipielle Aufbau von Folientastaturen ist in der DIN 42 115 (Entwurf) beschrieben. Hauptkomponente ist danach ein Folientastfeld, das aus vielen einzelnen Folientastelementen besteht. Folientastfelder und damit auch die Folientastelemente sind in der Regel aus 3 Schichten aufgebaut.

Die erste Schicht besteht aus einer flexiblen Grundfolie (meist Polyethylenterphthalat), die mit einer Leitpaste im Siebdruckverfahren bedruckt und anschließend bei Temperaturen unter 200°C getrocknet wird. Darauf bringt man eine sog. Spacerfolie an (beidseitig klebend), die an den Kontaktpunkten Aussparungen besitzt. Als dritte Schicht folgt wiederum meist eine Polyesterfolie, die innenseitig mit einer Leitpaste im Siebdruckverfahren bedruckt und anschließend getrocknet ist. Durch Druck von außen auf die oberste (dritte) Schicht an besonders gekennzeichneten Stellen (Spaceraussparungen) wird bei entsprechenden Siebdruckmustern ein Kontakt zwischen den Leiterbahnen der 1. und 3. Schicht hergestellt. Beim gleichzeitigen Anlegen einer Spannung an die beiden Leiterbahnebenen fließt dann ein Kurzschlußstrom, der einen Steuerungsimpuls auslöst.

Folientastaturen existieren in vielen Konstruktionsvarianten. Sie lassen sich prinzipiell in Systeme ohne und mit Druckpunkt (sogenannter Dom) einteilen. Aufgrund der immer stärker gewünschten taktilen Rückmeldung bei Folientastaturen gehen die Entwicklungen hin zu Konstruktionsvarianten mit geprägtem Dom. Dies beinhaltet eine Heißverformung der Folie mit den aufgebrachten Leiterbahnen. wodurch höchste Anforderungen an die Flexibilität, Langzeithaftung und Biegewechselbeständigkeit der Leiterbahnen gestellt werden.

In der US-PS 4 425 263 und in der EP-PS 0 068 168 werden siebdruckfähige, elektrisch leitende Pasten beschrieben, bestehend aus einem leitfähigen Metallpulver, einer organischen Binderkomponente und einem organischen Lösungsmittel, deren organische Binderkomponente aus einem aromatischen Polyesterharz besteht. Es werden bestimmte Flächenwiderstandswerte erreicht, die sich jedoch nach Knick- oder Biegevorgängen der gedruckten Leiterbahnen drastisch erhöhen, da die mit diesen Pasten erzeugten Leiterbahnen nicht ausreichend flexibel sind und brechen.

In der US-PS 4 592 961 wird über eine Verbesserung der Flexibilität von Silberleiterbahnen berichtet, wenn dem aromatischen Polyesterlackharz ein Vinyliden-copolymer zugesetzt wird. Derartige Pasten gelieren jedoch innerhalb kürzester Zeit und sind dann nicht mehr siebdruckfähig.

Die Verwendung von Epoxidharzen zur Herstellung von leitfähigen Massen und Leiterpasten ist bekannt. So wird in US-Patent 3 746 662 ein leitfähiger SilberEpoxidharzkleber beschrieben, der zum Befestigen von Bauteilen auf Trägermaterialien verwendet wird. Dieser Kleber besteht aus einem niedermolekularen, flüssigen Epoxidharz und enthält eine zusätzliche Härterkomponente. Auch in der FR-PS 2 505 543 wird eine leitfähige Masse aus Silberpulver, einem niedermolekularen Epoxidharz mit Härter und einem organischen Lösungsmittel zur Befestigung von elektronischen Bauteilen auf Substraten beschrieben. Beide Pasten sind aufgrund ihrer Sprödigkeit im ausgehärteten Zustand für Folientastaturen nicht geeignet.

Es war daher Aufgabe der vorliegenden Erfindung, eine siebdruckfähige Paste zur Herstellung elektrisch leitender Überzüge auf flexiblen Kunststoffolien, insbesondere zur Herstellung von Folientastaturen zu entwickeln, mit der knickbeständige, langzeitstabile Leiterbahnen erzeugt werden können. Außerdem sollten die aufgebrachten Leiterbahnen heiß verformbar und gut haftend sein, sowie eine hohe Ritz-und Kratzbeständigkeit aufweisen.

Diese Aufgabe wird erfindungsgemäß dadurch gelöst, daß eine Paste verwendet wird, bestehend aus 40 bis 75 Gew.% eines elektrisch leitfähigen Metallpulvers auf der Basis von Silber, Aluminium, Kupfer und deren Gemischen, 5 bis 20 Gew. % eines organischen Kunstharzes in Form eines thermoplastischen Epoxidoder Phenoxiharzes mit einem mittleren Molekulargewicht von 10 000 bis 250 000 und einem Epoxidgehalt (Aeq/kg) von 0 bis 1, und 5 bis 55 Gew.% eines organischen Lösungsmittels.

Vorzugsweise verwendet man Epoxid- oder Phenoxiharze, die aus Bisphenol A und Epichlorhydrin hergestellt sind. Als organische Lösungsmittel haben sich insbesondere Glycolether, Glycoletherester, Glycolester und Kohlenwasserstoffe bewährt.

Diese Leitpasten können im Siebdruckverfahren auf ein flexibles Substratmaterial, wie etwa Folien aus Polyester, Polycarbonat, Polyimid, Polyethersulfon (PES) oder Polyetheretherketon (PEEK), in einem geeigneten Muster aufgebracht und anschließend bei Temperaturen unter 200°C getrocknet werden.

Dabei entstehen elektrisch gut leitende Flächenbeschichtungen oder Leiterbahnen.

Für die Herstellung eines Folientastelementes werden zwei gleichgroße Folien mit der Leitpaste im Siebdruckverfahren mit einem Muster bedruckt und getrocknet. Die obere (Deck)-Folie wird dann in einem geeigneten Werkzeug bleibend heißverformt (Domprägevorgang).

Beide Folien werden anschließend unter Einbezug einer Spacerschicht mit Aussparungen passergenau verpreßt oder verklebt. Mit derartigen Folientastelementen wurden die dynamischen Langzeittests (1 Million Kurzschlußschaltspiele) durchgeführt. Nach Durchführung dieser Prüfung wurde der Schleifenwiderstand der Anordnung gemessen.

Hinsichtlich des in der Leitpaste verwendeten Silberpulvers haben sich plättchenförmige Partikel (sogenannte "flakes") als besonders geeignet erwiesen. Die bevorzugten Klopfdichten des plättchenförmigen Silberpulvers liegen bei 1,5 - 5 g/cm³. Jedoch können auch mikrokristalline, dendritische oder kugelige Silberpulver verwendet werden. Als Kupferpulver kommt bevorzugt plättchenförmiges Material mit durchschnittlichen Korngrößen kleiner 15 um zum Einsatz. Als Aluminiumpulver kann Material mit einer durchschnittlichen Korngröße kleiner 20 µm verwendet werden.

Das notwendige thermoplastische Harz aus der Klasse der Epoxid- bzw. Phenoxiharze muß ein durchschnittliches Molekulargewicht zwischen 10 000 und 250 000 aufweisen. Als Aufbaukomponenten solcher Harze werden bevorzugt Bisphenol A und Epichlorhydrin eingesetzt, jedoch können auch Epoxidharze eines anderen Aufbaus Verwendung finden. Die daraus resultierenden Harze müssen einen Epoxidgehalt kleiner 1 (Aeq/kg) haben. Vorzugsweise soll er bei den Epoxidharzen kleiner 0,5 sein. Der Epoxidgehalt bei den Phenoxiharzen ist definitionsgemäß O. Unter dem Epoxidgehalt versteht man die Anzahl Epoxidäquivalente (Val) in 1000 g Harz (Aeq/kg).

Ein Epoxidgehalt kleiner 1 bedeutet also. daß die Anzahl der reaktiven endständigen Epoxidgruppen des Harzes sehr gering ist. Damit können solche Harze ohne zusätzliche Härter verarbeitet werden.

Als Lösungsmittel kommen alle organischen Lösemittel mit gutem Lösevermögen zum Einsatz, insbesondere Mischungen aus der Klasse der Glykolether oder Glykoletheracetate, jedoch auch aromatische oder aliphatische Kohlenwasserstoffe. Es ist selbstverständlich, daß weitere Lackhilfsmittel zugesetzt werden können. So ist der Zusatz von Weichmachern und Weichharzen zur Erhöhung der Flexibilität allgemein bekannt.

Auch die Zugabe von Stabilisatoren, Entlüftern. Entschäumern, Thixotropiermitteln usw. zu den erfindungsgemäßen Leitpasten ist möglich.

Die folgenden Beispiele sollen die Erfindung näher erläutern:
1. Man bereitet eine Losung von 40 Gew. % Phenoxiharz PKHH (Fa. Union Carbide; Molekulargewicht 20 000 - 30 000, Epoxidgehalt O) in 60 Gew. % Ethyldiglykolacetat. 22,5 Gew. % dieser Harzlösung werden mit 60 Gew. % plättchenförmigem Silberpulver (Stampfdichte 3,5 g/cm³) und 17,5 Gew. % Ethyldiglykolacetat vermischt und zu einer Paste verarbeitet. Die Paste weist eine Viskosität von ca. 5500 mPas (gemessen mit HAAKE Rotovisco RV 20. Pk I, 0,3°, D = 200 sec⁻¹, T = 20°C) auf.
   Das Präparat wird im Siedruckverfahren auf Polyesterfolien (Typ Hostaphan RN 125, Fa. Kalle, Wiesbaden) aufgebracht und bei 120°C für 30 min getrocknet.
   Man erhält sehr gut elektrisch leitfähige Leiterbahnen. die einen Flächenwiderstand von ca. 40 m Ω/□ (bezogen auf eine Schichtdicke von 10 µm aufweisen. Nach der Lagerung der Leiterbahnen unter den Klimabedingungen 85°C/85 % rel. F. für 1000 Stunden tritt keine Verschlechterung des Flächenwiderstandes ein.
   Mit dieser Leiterpaste wird ein Folientastelement hergestellt. Dabei druckt man die Leiterbahn auf eine dünne Polyesterfolie, trocknet bei 120°C für 30 min und verformt anschließend dieses Gebilde bei ca. 100°C in einer Prägevorrichtung zur Herstellung eines Schalt"Domes". Die so behandelte Schaltfolie wird auf einer Basisfolie befestigt, und ein Schaltelement hergestellt.
   Dieses Folientastelement wird einem Dauertest von 1 Million Schaltspielen unterzogen, wobei zu Beginn und zum Ende des Tests der Schleifenwiderstand der Anordnung vermessen wird.
   Das Folientastelement absolviert 1 Million Schaltspiele ohne Ausfall, der Ausgangswert des Schleifenwiderstandes liegt bei 0.56 Ω, der Endwert bei 6,2 Ω. Die Haftung der Leiterpaste auf dem Schaltdom ist auch nach 1 Million Schaltspielen noch sehr gut.
2. Man mischt 65 Gew. % plättchenförmiges Silberpulver (Stampfdichte 4.0 g/cm³) mit 26 Gew. % der Epoxidharzlösung Araldit GJ 488 E32 (Fa. Ciby-Geigy, Wehr; Molekulargewicht ca. 20 000, Epoxidwert 0,15). Anschließend gibt man 9 Gew. % Ethyldiglykolacetat als Verdünnung zu und stellt eine Leiterpaste her.
   Die Paste weist eine Viskosität von ca. 4000 mPas (gemessen mit dem HAAKE Rotovisco RV 20. Bedingungen wie in Beispiel 1) auf. Der Flächenwiderstand des Präparates beträgt 30 m Ω/□ (bezogen auf eine Schichtdicke von 10 µm. Nach der Lagerung der Leiterbahnen unter den Klimabedingungen 85°C/85 % rel. F. für 1 000 Stunden tritt keine Verschlechterung des Flächenwiderstandes ein.
   Mit dieser Paste werden Folientastelemente gemäß Beispiel 1 hergestellt und einem Dauertest von 1 Million Schaltspielen Unterzogen. Die Folientastelemente absolvieren 1 Million Schaltspiele ohne Ausfall, der Ausgangswert des Schleifenwiderstandes liegt bei 0,42 Ω der Endwert bei 2,5 Ω.
   Die Haftung der Leiterpaste auf dem Schaltdom ist auch nach 1 Million Schaltspielen sehr gut.

## Patentansprüche

1. Verwendung einer siebdruckfähigen Paste, bestehend aus 40 bis 75 Gew. % eines elektrisch leitfähigen Metallpulvers auf der Basis von Silber, Aluminium, Kupfer und deren Gemischen, 5 bis 20 Gew. % eines organischen Kunstharzes in Form eines thermoplastischen Epoxid- oder Phenoxiharzes mit einem mittleren Molekulargewicht von 10 000 bis 250 000 und einem Epoxidgehalt von 0 bis 1 Aeq/kg und 5 bis 55 Gew. % eines organischen Lösungsmittels, zur Herstellung elektrisch leitender Überzüge auf flexiblen Kunststoffolien, insbesondere zur Herstellung von Folientastaturen.

2. Verwendung einer siebdruckfähigen Paste nach Anspruch 1,
dadurch gekennzeichnet,
daß die Epoxid- oder Phenoxiharze aus Bisphenol A und Epichlorhydrin hergestellt sind.

3. Verwendung einer siebdruckfähigen Paste nach Anspruch 1 und 2,
dadurch gekennzeichnet,
daß als organische Lösungsmittel Glycolether, Glycoletherester, Glycolester und Kohlenwasserstoffe eingesetzt werden.

4. Verfahren zur Herstellung von elektrisch leitenden Überzügen auf flexiblen Kunststoffolien für Folientastaturen,
dadurch gekennzeichnet,
daß siebdruckfähige Pasten aus 40 bis 75 Gew. % eines elektrisch leitfähigen Metallpulvers auf der Basis von Silber, Aluminium, Kupfer und deren Gemischen, 5 bis 20 Gew. % eines organischen Kunstharzes in Form eines thermoplastischen Epoxidoder Phenoxiharzes mit einem mittleren Molekulargewicht von 10 000 bis 250 000 und einem Epoxidgehalt von 0 bis 1 Aeq/kg und 5 bis 55 Gew. % eines organischen Lösungsmittels als Schicht auf eine flexible Kunststoffolie im Siedruckverfahren aufgebracht und bei Temperaturen unter 200° C getrocknet werden.

## Claims

1. The use of a paste suitable for screen printing, consisting of from 40 to 75% by weight of an electrically conductive metal powder based on silver, aluminium, copper and mixtures thereof, from 5 to 20% by weight of an organic synthetic resin in the form of a thermoplastic epoxide or phenoxy resin having an average molecular weight of from 10,000 to 250,000 and an epoxide content of from 0 to 1 equivalents per kg and from 5 to 55% by weight of an organic solvent, for the production of electrically conductive coatings on flexible plastics films, in particular for the production of film keyboards.

2. The use of a paste suitable for screen printing according to Claim 1, characterised in that the epoxide or phenoxy resins are prepared from bisphenol A and epichlorohydrin.

3. The use of a paste suitable for screen printing according to Claims 1 and 2, characterised in that the organic solvents used are glycol ethers, glycol ether esters, glycol esters and hydrocarbons.

4. A process for the production of electrically conductive coatings on flexible plastics films for film keyboards, characterised in that pastes suitable for screen printing composed of 40 to 75% by weight of an electrically conductive metal powder based on silver, aluminium, copper and mixtures thereof, from 5 to 20% by weight of an organic synthetic resin in the form of a thermoplastic epoxide or phenoxy resin having an average molecular weight of from 10,000 to 250,000 and an epoxide content of 0 to 1 equivalents per kg and from 5 to 55% by weight of an organic solvent are applied in the form of a layer to a flexible plastics film in the screen printing process and dried at temperatures below 200°C.

## Revendications

1. Utilisation d'une pâte sérigraphique de 40 à 75 % en poids d'une poudre métallique électriquement conductrice à base d'argent, d'aluminium, de cuivre et de leurs mélanges, 5 à 20 % en poids d'une résine organique de synthèse sous forme d'une résine thermoplastique époxyde ou phénoxy avec un poids moléculaire moyen de 10000 à 250000 et une teneur en époxyde de 0 à 1 équ./kg et 5 à 55 % en poids d'un solvant organique, pour réaliser des revêtements électriquement conducteurs sur des films souples en matière plastique, notamment pour produire des claviers en film.

2. Utilisation d'une pâte sérigraphique selon la revendication 1, caractérisée en ce que les résines époxydes ou phénoxy sont préparées à partir de bisphénol A et d'épichlorhydrine.

3. Utilisation d'une pâte sérigraphique selon la revendication 1 et 2, caractérisée en ce qu'on utilise comme solvants organiques des éthers de glycols, des éther-esters de glycols et des hydrocarbures.

4. Procédé de production de revêtements électriquement conducteurs sur des films souples de matière plastique pour des claviers à effleurement, caractérisé en ce que des pâtes sérigraphiques, constituées de 40 à 75 % en poids d'une poudre métallique électriquement conductrice à base d'argent, d'aluminium, de cuivre et de leurs mélanges, 5 à 20 % en poids d'une résine organique de synthèse sous forme d'une résine thermoplastique époxyde ou phénoxy avec un poids moléculaire moyen de 10000 à 250000 et d'une teneur en époxyde de 0, à 1 équ./kg et 5 à 55 % en poids d'un solvant organique, sont déposées comme couche sur un film de matière plastique souple en procédé de sérigraphie et on sèche à des températures inférieures à 200°C.
